# EUROPEAN PATENT SPECIFICATION

(11) **EP 0 313 174 B1**
(45) Date of publication and mention of the grant of the patent: **22.09.1993**
(21) Application number: 88202641.2
(22) Date of filing: 14.11.1984
(51) Int. Cl.: H01L 33/00, H01L 31/02, H01L 31/18

(54) **Method for producing optical devices and packages**
Herstellungsverfahren von optischen Anordnungen und Halterungen
Méthode de production de dispositifs optiques et de boîtiers

(30) Priority: 21.11.1983 JP 218964/83; 25.11.1983 JP 223020/83; 08.12.1983 JP 232341/83
(43) Date of publication of application: 26.04.1989
(62) Divisional of application: 84307870.0
(73) Proprietor: SUMITOMO ELECTRIC INDUSTRIES LIMITED, Osaka-shi, Osaka 541 (JP)
(72) Inventor: Nishizawa, Hideaki, 1-3, Shimaya 1-chome Konohana-ku Osaka (JP)
(74) Representative: Rackham, Stephen Neil

(56) References cited:
- EP-A- 0 017 701
- EP-A- 0 127 401
- WO-A-82/02800
- US-A- 3 757 127
- PATENT ABSTRACTS OF JAPAN, vol. 4, no. 44 (E-5)[526], 5th April 1980, page 19 E 5; & JP-A-55 13 963 (NIPPON DENKI K.K.) 31-01-1980
- PATENT ABSTRACTS OF JAPAN, vol. 5, no. 121 (E-68)[793], 5th August 1981; & JP-A-56 60 037 (MITSUBISHI DENKI K.K.) 23-05-1981
- PATENT ABSTRACTS OF JAPAN, vol. 7, no. 186 (E-193)[1331], 16th August 1983; & JP-A-58 91 644 (TOKYO SHIBAURA DENKI K.K.) 31-05-1983

## Description

The present invention relates to methods for producing optical devices such as light-emitting diodes and photodiodes, and packages for such optical devices.

In an optical device such as a light emitting device or a light receiving device, and a package for such optical device, there are the following technological requirements:
(a) It must have a light transmitting structure which is transparent to light;
(b) It must be wired by die bonding or wire bonding to lead electrode terminals out of it;
(c) Its chip must be sealed off hermetically; and,
(d) It must have a high coupling efficiency with an optical fibre. That is, a light emitting diode chip or a photodiode chip must be capable of being mounted sufficiently closely to an optical fibre end face and must have a large opening angle to obtain the greatest degree of coupling. Further, the chip must have a clean light receiving or transmitting surface which is not obscured with any other material.

Various attempts have been made to improve devices to meet the above requirements, particularly requirement (d) and a number of these will be discussed subsequently.

According to a first aspect of this invention a method of producing an optical device comprises the steps of:
providing a substrate, the substrate being either transparent or having a hole for passing light through it;
forming a die bonding pad on the substrate; and
die bonding an optical device chip arranged to transmit light into or out of it from its die-bonded side on to the die bonding pad;
characterised in that the optical device chip has an electrode and a solder layer sequentially formed on its die-bonded side, the solder layer having a predetermined thickness, each layer having a hole for transmission of light, and in that the optical device chip is die-bonded to the die bonding pad by the solder layer forming a depression having inclined sides in the upper surface of the substrate;
and the step of providing a die bonding pad includes forming the pad on the upper surface of the substrate by printing and firing electroconductive paste, the electroconductive paste having its edges located on the inclined sides of the depression, so that, after firing the upper contact surface of the die bonding pad is substantially flat.

The optical device chip may be a photodiode with the electrode being formed on the light receiving surface of the photodiode. Preferably the step of providing a substrate comprises providing a sapphire substrate.

Particular examples of methods in accordance with this invention will now be described and contrasted with conventional methods with reference to the accompanying drawings; in which:-
Figure 1 is a section through a conventional upper surface type package for an optical device, having a glass window in the upper surface;
Figure 2 is a section through a conventional upper surface type package for an optical device, having a sapphire window in the upper surface;
Figures 3 to 5 are sections through conventional lower surface through hole type packages for an optical device;
Figure 6 is a section to a larger scale illustrating the light incident on a light receiving portion in a conventional lower surface through hole type optical device;
Figure 7 is a section to a larger scale illustrating the light incident on a light receiving portion in a conventional lower surface through hole type optical device when an optical device chip is not mounted in its required position;
Figure 8 is a plan of a conventional sapphire substrate type of package with its cover removed;
Figure 9 is a section taken along the line IX-IX shown in Figure 8;
Figure 10 is a section through a complete optical device in which an optical device chip is die-bonded into the package shown in Figure 9;
Figure 11 is a plan to a larger scale of a portion of the die bonding pad;
Figure 12 is a section taken along the line XII-XII shown in Figure 11;
Figure 13 is a section to a larger scale showing the gold paste screen-printed on a sapphire substrate;
Figure 14 is a section to a larger scale showing the state of the sapphire substrate with the die bonding pad formed by gold paste after firing;
Figure 15 is a section to a larger scale showing an optical device chip mounted on the die bonding pad;
Figure 16 is a section through an example of a conventional mesa type photodiode chip;
Figure 17 is a section through a conventional ceramic substrate type bonding pad having a light introducing hole;
Figure 18 is a section through the conventional ceramic substrate bonding pad having a solder ring mounted on it;
Figure 19 is a section through a complete device in which a photodiode chip is mounted on the substrate shown in Figure 18;
Figure 20 is a section similar to Figure 18 but illustrating a package in which the solder ring is mounted off its required position;
Figure 21 is a section similar to Figure 19 showing a complete device in which a photodiode chip is mounted on the package shown in Figure 20;
Figure 22 is a section through a sapphire substrate;
Figure 23 is a section through the sapphire substrate shown in Figure 22 modified in accordance with an aspect of this invention;
Figure 24 is a section through the substrate shown in Figure 23 with gold paste screen-printed on to it;
Figure 25 is a section through the substrate shown in Figure 24 after firing;
Figure 26 is a section through a device illustrating the relationship between the light receiving portion and the opening angle of the optical device chip;

### Prior Art I Upper Surface Type

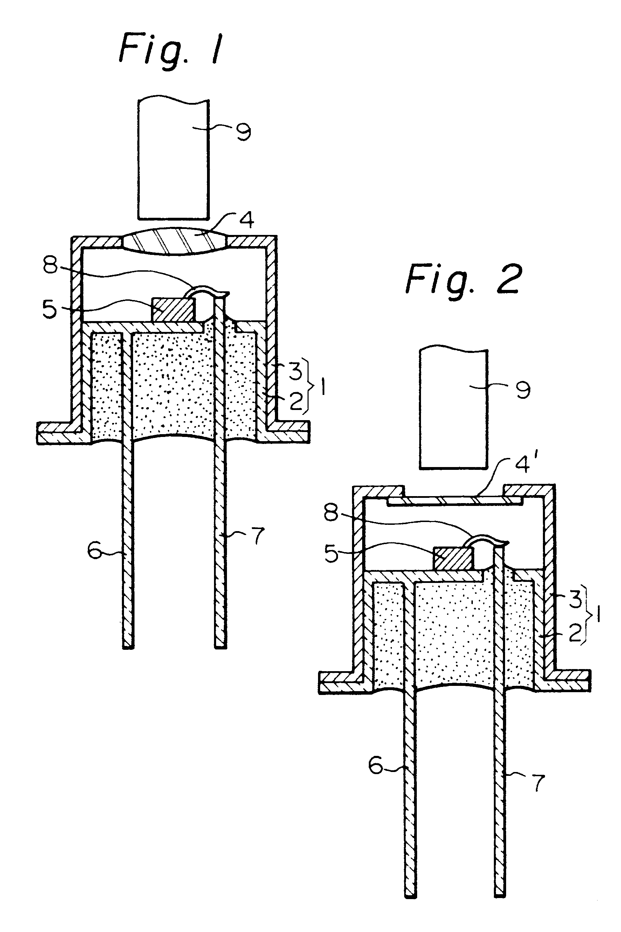

Figure 1 is a sectional view of a prior art package for a photodiode. This package is a most common type in which light of an optical fibre is incident to it through the upper surface of it. In Figure 1, a T018 type package 1 comprises a package body 2 and a cap 3 to cover the upper surface of the body 2. The cap 3 has an opening at the centre of the top thereof, which has a transparent kovar glass therein to serve as a window 4. A photodiode chip 5 is die-bonded to the top plate of the package body 2. The top plate of the package body 2 is provided with a lead 6. Another lead 7 and an electrode on the photodiode chip 5 are wire-bonded with each other by a gold wire 8. An optical fibre 9 is disposed outside of the window 4 in opposition to the photodiode chip 5.

The cap 3 and the body 2 are welded together on their sides. This package is of a hermetically sealed type which has been bringing satisfactory results for a long time. In this package, since light is incident on to it from the upper surface where the wire bonding (gold wire 8) exists, the window 4 must be spaced from the upper surface of the photodiode chip 5 and this results in a disadvantage that the coupling efficiency with the optical fibre 9 is low.

Figure 2 shows another package for an optical device of the upper surface type as shown in Figure 1, in which a sapphire plate 4′ is mounted in the window in place of the transparent kovar glass 4. The package shown in Figure 2 has likewise the disadvantage that the coupling efficiency with the optical fibre 9 is low because the photodiode chip 5 and the sapphire plate 4′ are separated from each other by sufficient distance to accommodate the gold wire 8 wire-bonded to the chip 5.

### Prior Art II Through Hole on Under Surface Type

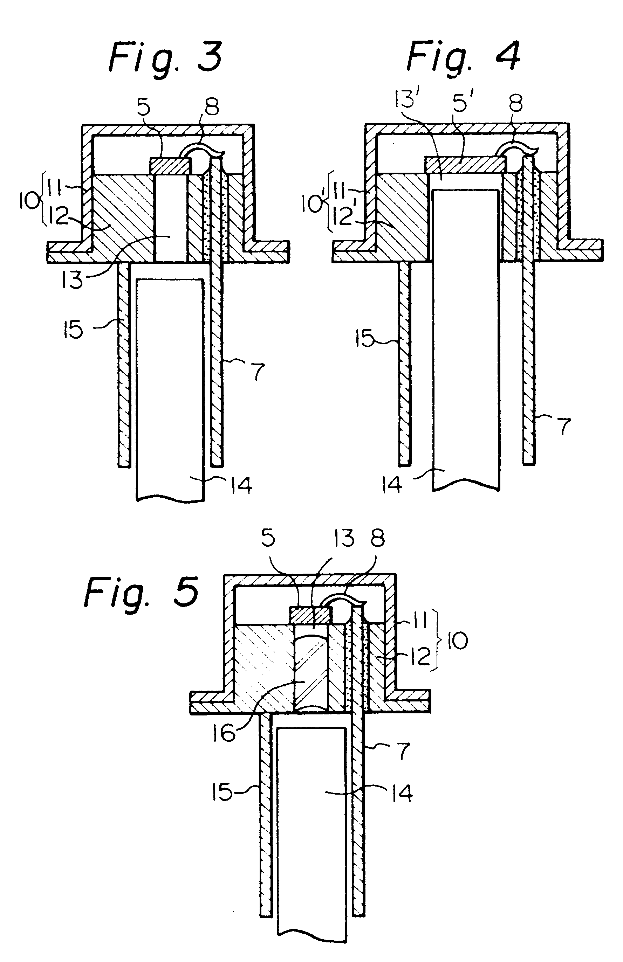

It is easier to get the optical fibre and the chip close to each other from the under surface than from the upper surface because the wire on the upper surface gives a limit to the closeness of approach from the upper surface. Therefore, through hole on under surface type packages for an optical device shown in Figures 3 to 5 have been produced. In Figure 3, a package 10 comprises a package body 12 and a cap 11. In this example, the cap 11 has no window. The package body 12 is provided with a large through hole 13 defined axially under the photodiode chip 5. An optical fibre 14 is disposed under the through hole 13 having its upper end face opposed to the lower opening of the through hole 13. The light from the optical fibre 14 is incident on the photodiode chip 5 from its under surface through the through hole 13. In Figures 3 to 5, designated by numeral 15 are leads equivalent to the leads 6 in Figures 1 and 2.

Figure 4 shows an example of the package in which the through hole 13′ is larger and the upper end portion of the optical fibre 14 is inserted into it and fixed to reduce the distance between the photodiode chip 5′ and the end of the optical fibre 14 still further. This example has, however, the disadvantages that the upper end of the optical fibre 14 inserted into the through hole 13′ may come in contact with the photodiode chip 5′ and damage it and that the fixing of the optical fibre 14 is difficult.

Figure 5 shows an example of the package in which the through hole 13 is sealed off by a kovar glass piece 16.

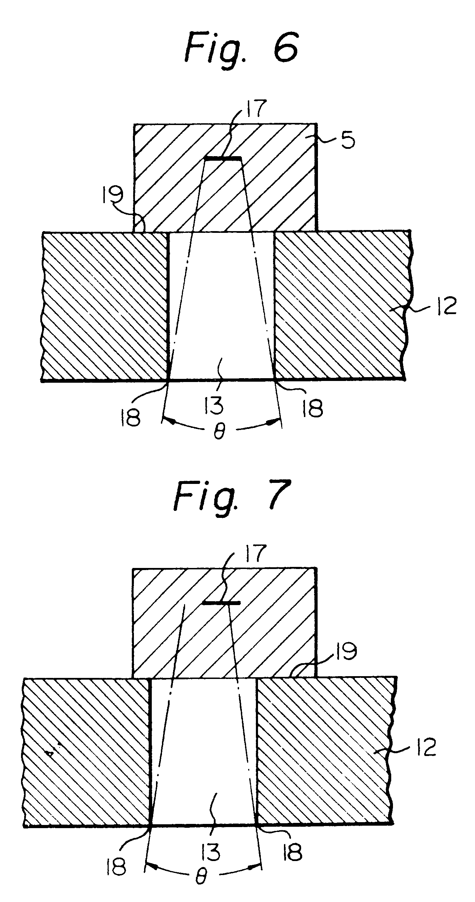

Disadvantages of these through hole on under surface type packages will be described with reference to enlarged sectional views of Figures 6 and 7 taking the case of Figure 3 as an example.

A pn junction of the photodiode chip 5 behaves as a light receiver 17 to which the light is incident from below through the through hole 13. Since the light is limited by the edge 18 of the through hole 13, only the light within the opening angle ϑ reaches the light receiver 17. Even if the end face of the optical fibre 14 is brought into contact with the under surface of the package body 12, it is still limited by the opening angle ϑ.

Mounting of the photodiode chip 5 is difficult. The through hole 13 is round in section and the photodiode chip 5 is die-bonded to the cap 11 on the contact region 19 exclusive of the through hole 13. Since the chip 5 is small and the through hole 13 is also small in section, alignment of them is difficult. If the centre of the light receiver 17 is displaced to one side of the central axis of the through hole 13, as shown in Figure 7, the quantity of light received by the light receiver 17 is smaller on the side to which it is displaced than on the other side. In Figure 7, the chip 5 is displaced to the right side and, accordingly, a smaller quantity of light reaches the right half of the light receiver 17 than its left half. Reduction in the quantity of the light incident to the photodiode decreases the detection sensitivity.

To enlarge the opening angle of the light incident on the light receiver 17, the through hole 13 must be reduced in length and increased in cross sectional area. The length of the through hole 13 is equal to the thickness of the package body 12. Reduction in thickness of the package body 12 makes its mechanical strength insufficient. The body 12 is made of metal or ceramic and it cannot be reduced in thickness unduly because it is the mechanical centre to support the chip, lead and cap. A larger diameter of the through hole 13 necessitates a larger size of the photodiode chip 5, and a larger size of semiconductor results in higher cost and lower strength of the chip.

### Prior Art III Sapphire Substrate Type

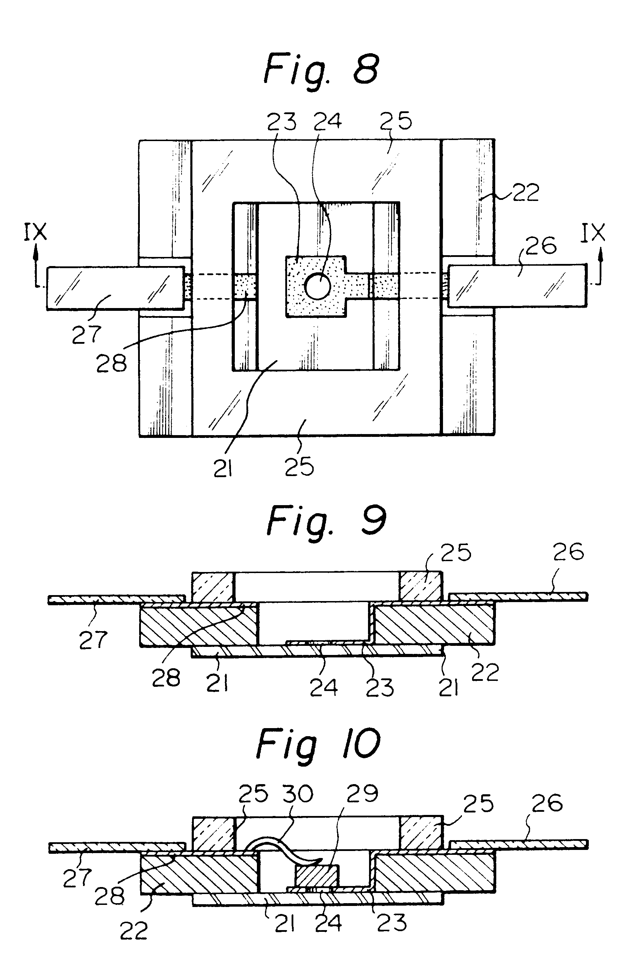

Accordingly, we have previously invented a package for an optical device, in which a sapphire substrate is provided with a die bonding pad having an opening, an optical device is die-bonded to the pad, and an end of an optical fibre is placed adjacent the rear face of the sapphire substrate. Figures 8, 9 and 10 show such a package.

In the structure of the package shown in Figures 8 to 10, a lower frame 22 is bonded to a sapphire substrate 21. The lower frame 22 is made of sintered alumina in this example but may be made of any insulator. The lower frame 22 is bonded to the sapphire substrate 21 by brazing. An electroconductive die bonding pad 23 having an opening 24 is disposed at the centre of the sapphire substrate 21 by metallizing. The die bonding pad 23 extends beyond an inner edge of the lower frame 22 to an outer edge thereof. The opening 24 is for passing light. While the opening 24 is shown as round in shape, it may, of course, be of other shape, for example, square. An upper frame 25 is bonded to the lower frame 22. The upper frame 26 and the lower frame 22 are bonded together by an insulating bonding agent. A lead 26 is soldered to the extended portion of the die bonding pad 23. A wire bonding pad 28 is metallized to the inner edge of the lower frame 22 opposite to the die bonding pad 23. A lead 27 is soldered to the extended portion of the wire bonding pad 28. An optical device chip 29 such as a photodiode or a light emitting diode is bonded to the package as shown in Figure 10. The optical device chip 29 is mounted on the die bonding pad 23 in such a way that the opening 24 and the optical device chip 29 are aligned with each other. The die bonding pad 23 is a solder ring of, for example, an AuSn eutectic crystal. By applying energy such as ultrasonic wave to the optical device chip 29 which is held down, the solder is melted to fix the chip 29 on the pad 23. Further, a wire 30 of, for example, gold is wire-bonded to connect the wire bonding pad 28 with the electrode of the optical device chip 29. Normally, an alumina cap is bonded to the upper frame 25 to seal off the inner space of the package.

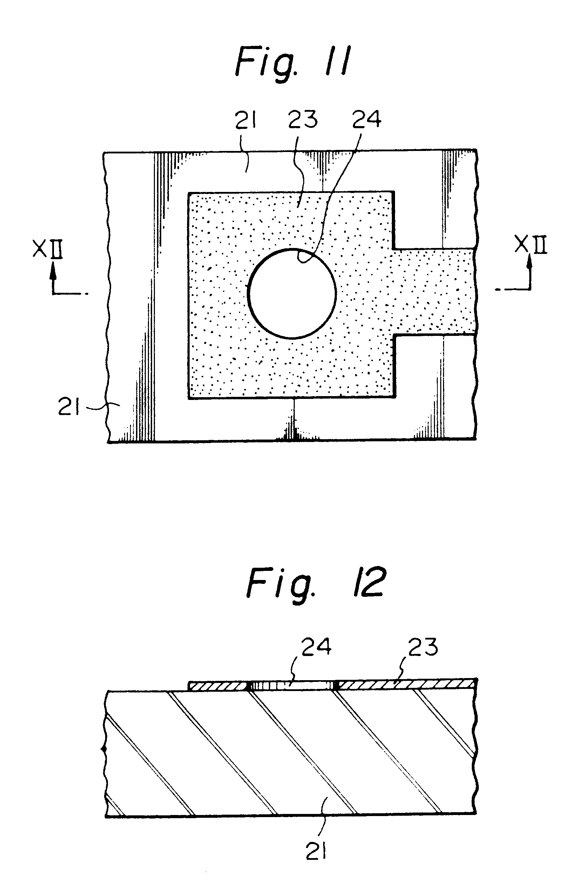

Figure 11 is an enlarged plan view of a portion of the die bonding pad 23 surrounding the opening 24, and Figure 12 is a sectional view taken along the line XII-XII of Figure 11. Ideally, the sapphire substrate 21 and the die bonding pad 23 would both be flat as shown in Figure 12 but, in practice this does not happen. If the pad 23 is perfectly flat, the optical device chip 29 can be fixed accurately at the predetermined position in a stable state. Actually, however, the die bonding pad 23 is not flat for the reason described below.

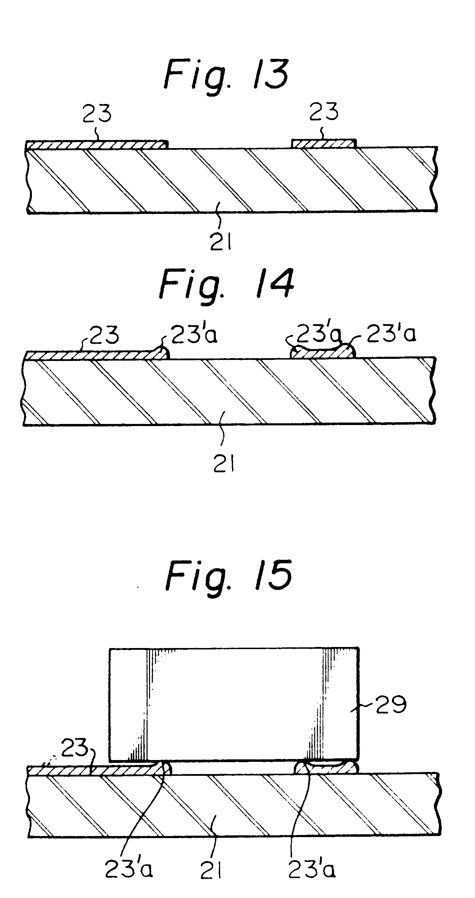

Figure 13 is a sectional view of the sapphire substrate during production in which paste of an electroconductive material (for example, gold or AuSn eutectic crystal) is printed on the sapphire substrate 21 in a silk screen printing operation. Since it is thick film printing, a thin screen with an opening identical in shape to the pad is placed on the sapphire substrate 21, and gold paste 23′ is applied onto the screen. In this state, the applied gold paste 23′ is flat in its upper surface. Then, the sapphire substrate 21 is placed in a furnace and fired to solidify the gold paste. In the firing process, the gold paste 23′ rises up at edges 23′a by a surface tension effect. For this reason, the gold paste 23′ becomes higher at edges 23′a than in other portions. When removed from the furnace, the gold paste solidifies in an indeterminate shape. Figure 14 is a sectional view of a typical pad after the firing process. Figure 15 is a sectional view of the pad on which the optical device chip 29 is die-bonded. Depressions and bumps are caused on the upper surface of the paste by expansion and contraction of the paste during the firing process. The depressions and bumps on the paste are approximately several µm in height, but since the optical device chip 29 is also small in size, the flat chip tends to be inclined or incompletely fixed when bonded to a die-bonding pad having such depressions and bumps. Further, the chip is easily detached by a weak shock or vibration.

### Prior Art IV Mesa Type Photo Diode

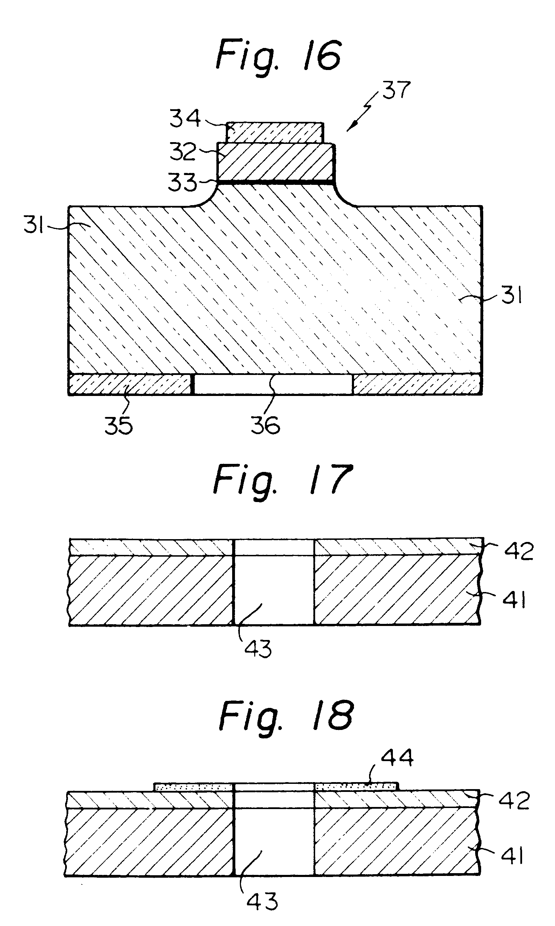

Another problem is high speed operation of the photodiode. Since the photodiode is used in an inversely biased state, the electrostatic capacity in the pn junction obstructs its high speed operation. Reduction in area of the light receiving region (pn junction) is effective to reduce the electrostatic capacity. For this purpose, a mesa structure as shown in Figure 16 is used.

A p-InP layer 32 is formed on an n-InP substrate 31 as by epitaxial growth. A narrow pn junction 33 between the substrate 31 and the layer 32 functions as the light receiving region. Further, the p-InP layer 32 and the pn junction 33 are etched off in stripes toward the upper portion of the n-InP substrate 31 on both sides to reduce the area of the light receiving region. Since the p-InP layer 32 is narrowed in stripes, a ring-shaped electrode can no longer be mounted on it. Accordingly, a stripe-shaped p-type Au-Zn electrode 34 is used. Then, it is impossible to pass the light from the p-layer. Instead a ring-shaped n-type AuGeNi electrode 35 is fixed to the bottom of the n-InP substrate 31. Then, the central portion of the bottom of the n-InP substrate 31 serves as a light receiving surface 36 through which the light passes. Therefore, under surface incident types shown in Figures 3, 4, 5 and 8 to 12 are demanded also for high speed operation of the photodiode.

A chip 37 of the photodiode described above is made by a wafer process in which, after a number of devices are made, the wafer is scribed and divided into chips 37. The chip 37 must be packaged. There is a further problem in mounting the photodiode chip 37 on the pad. An example of an assembly of this type is disclosed in WO-A-8202800.

### Prior Art V Ceramic Substrate Type

As an example intermediate between the example shown in Figures 3 to 5 and the example shown in Figures 8 to 12, there is a package using a ceramic substrate having a hole therethrough. Since the ceramic substrate is not conductive, a metal is evaporated on to it to form a die bonding pad which is slightly different in technical meaning from the pad of the example described in the preceding paragraph. Solder is placed on the pad, on which an optical device is placed and soldered.

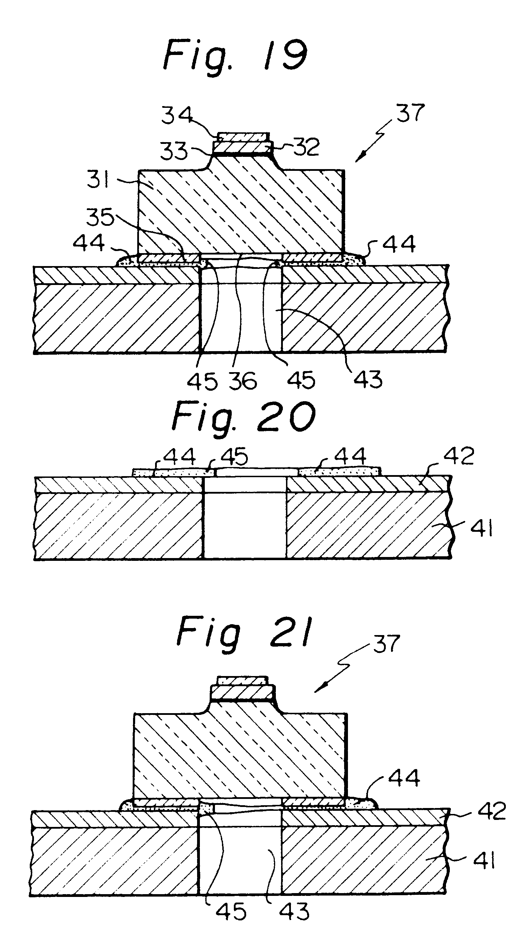

Figures 17 to 21 are sectional views showing in order the steps for assembly of a package of the ceramic substrate type. As shown in Figure 17, an electroconductive bonding pad 42 is mounted on a ceramic substrate 41 as by evaporation and a light introducing hole 43 is made through it. Then, as shown in Figure 18 a preformed solder ring 44 of Au-Sn is placed around the light introduction hole 43. Thereafter, as shown in Figure 19, the photodiode chip 37 is placed on the solder 44 and heated in a furnace to solder it.

In this structure, even through the preformed solder ring 44 and the light introduction hole 43 are aligned with each other correctly, when the chip 37 is soldered, a portion 45 of the solder sometimes overflows from the position to cover at least part of the light receiving surface thereby reducing its light receiving area. In many cases, the position of the preformed solder ring 44 is displaced to one side as shown in Figure 20. In this case, when the chip 37 is placed and soldered, there could be caused the wide overflow 45 toward one side, which covers the light receiving surface and thereby reduces the sensitivity of the photodiode. While the overflow 45 of the solder can be avoided by reducing the thickness of the solder, the thickness of the preformed solder ring must be 10 µm or larger for convenience in handling. For the reason described above, such a preformed ring 44 can reduce the light receiving area on the bottom surface of the chip to lower the sensitivity of the photodiode. Another problem is bonding strength. In the case where a solder ring preform (for example, AuSn alloy of 500 µm outer diameter, 250 µm inner diameter, and 30 µm thickness) is used for die bonding there is a time lag between melting of the preform and die bonding of the photodiode, which causes a problem of uneven contact between the bottom surface of the photodiode and the solder 44, resulting in variation in the strength of the die bonding.

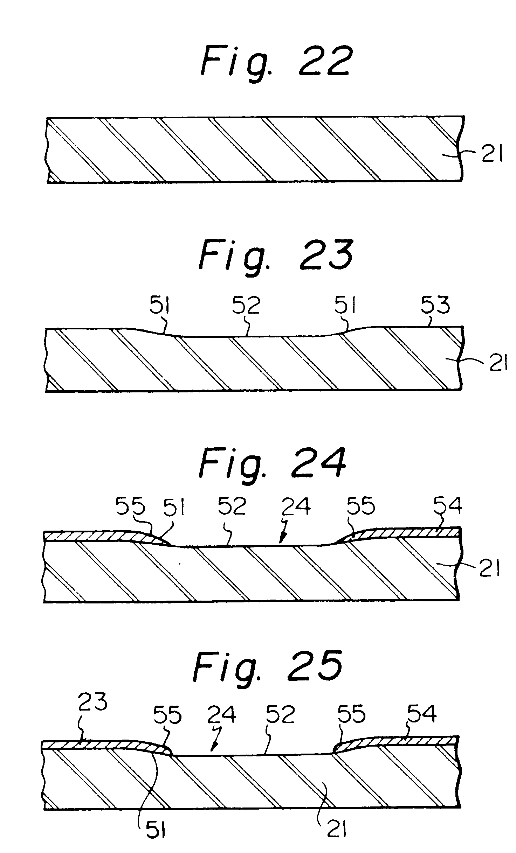

Preferred embodiments of the present invention will now be described. First of all, an embodiment for overcoming the problem in metallizing the die bonding pad 23 in a package for an optical device shown in Figures 8 and 9 will be described with reference to Figures 22 to 25. Since the problem in metallizing the die bonding pad is caused by the rising of gold paste at its edges, the sapphire substrate 21 is slightly shaved beforehand to a depth corresponding to the amount of rising of the paste in its edges.

Figure 22 is a sectional view of the sapphire substrate 21 which is flat and transparent, and is 0.2 mm in thickness in this example.

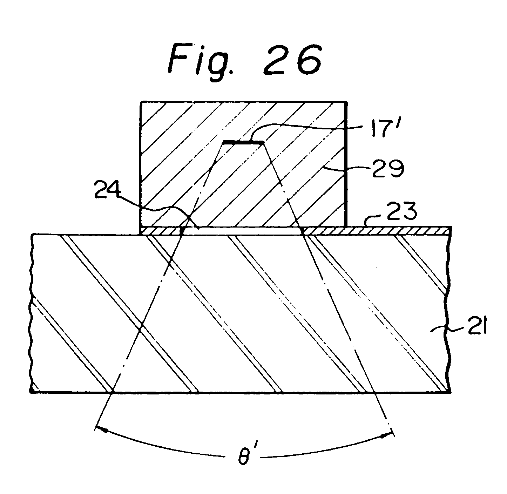

Figure 23 shows the flat sapphire substrate 21 provided with a shallow inclined portion 51 and a concavity 52 continuous thereto. The inclined portion 51 and the concavity 52 are processed by an Ar laser, but may be processed mechanically. The difference in height between an unprocessed upper surface 53 and the flat base of the concavity 52 is in the range 5 to 10 µm. Then, as shown in Figure 24, electroconductive paste 54 such as gold paste is screen-printed on the substrate 21 in the shape to be the die bonding pad 23 in such a manner that the base of the concavity 52 corresponds to the opening 24 of the pad 23. Edges 55 corresponding to the opening 24 of the paste 23 are inclined smoothly toward the concavity 52. The screen-printed paste is dried and fired in a furnace. Figure 25 is a sectional view of the sapphire substrate 21 and the paste 54 thereon after firing. By firing, the paste 54 rises in the ends 55 in height no more than 5 µm. Since the edges of the paste are located on the inclined portion 51, the edges of the paste do not rise higher than other portions of the paste so that its upper surface is substantially flat. The optical device chip 29 is die-bonded to the die bonding pad 23 thus processed. Since the rising in the ends of the paste is levelled off, there is no unequal raising of the bottom surface of the chip 29. Thereafter, a package for optical device as shown in Figures 8 and 9 is produced as described previously. Then, as shown in Figure 10, the optical device chip 29 is die-bonded, the wire 30 is wire-bonded and cap-sealed to form an optical device.

The package for optical device structured as described above provides the following meritorious technical effects:
(a) Safety in die bonding of the optical device chip is increased. After the gold paste is fired, the rising of its edges is substantially flat or even still below the level of its surroundings. Thus the surface of the optical device chip is in contact with the flat portions only of the die bonding pad to make the entire contact surface flat.
(b) The packaging of this optical device chip is, unlike that of the under surface through hole type shown in Figure 6, not severely limited in the opening angle. In the structure of the packaging as shown in Figure 26, the light reaching the light receiving portion 17' passes the opening 24 of the pad 23. The opening 24 is in contact with the chip 29 and is very thin. Accordingly, it is possible to let the light included in the wide opening angle r' be incident to the light receiving portion 17'.

While the present invention has been described hereinabove with reference to the specific applications, it will be understood that the present invention is applicable to all optical devices such as planar type photodiodes, avalanche photodiodes (APD) and further to packaging of plane light transmission type light transmitting diodes and plane light transmission type laser diodes.

The optical device having the structure according to the present invention as described above provides the meritorious technical effects as follows:
(a) Since overflow or dislocation of the solder layer in die bonding is prevented, there is no reduction in area or space of the transparent portion for passing light by the solder. This increases the yield rate in assembly of the optical devices. When applied to a photodiode, the present invention does not decrease the sensitivity of the photodiode because the photodiode is provided with a metallized layer of such, for example, as Sn in the die bonding area other than the light receiving window. Since the thickness of the metallized layer of such as Sn can be arbitrarily controlled in the accuracy of 0.2 µm, there is no overflow of the solder.
(b) It is not necessary to provide special die-bonding agent such as solder or epoxy resin in die bonding. This makes production process simple and productivity high.

## Claims

1. A method of producing an optical device comprising the steps of:
providing a substrate (21, 41), the substrate (21, 41) being either transparent or having a hole (24, 43) for passing light through it;
forming a die bonding pad (54, 42) on the substrate (21, 41); and
die bonding an optical device chip (29, 37) arranged to transmit light into or out of it from its die bonded side (61) on to the die bonding pad (54, 42);
characterised in that the optical device chip (29, 37), has an electrode (35) and a solder layer (44) sequentially formed on its die bonded side, the solder layer (66) having a predetermined thickness, the solder layer (44) and the electrode (35) having a hole for transmission of light, and in that the optical device chip is die bonded to the die bonding pad (54, 42) by the solder layer (44) and in that the step of providing a substrate includes:
forming a depression (52) having inclined sides (51) in the upper surface of the substrate (21);
and the step of providing a die bonding pad (54) includes forming the pad (54) on the upper surface of the substrate (21) by printing and firing electroconductive paste, the electroconductive paste (54) having its edges located on the inclined sides (51) of the depression (52), so that, after firing the upper contact surface of the die bonding pad (23) is substantially flat.

2. A method according to claim 1, in which the substrate (21) is sapphire.

3. A method according to any of the preceding claims, in which the predetermined thickness of the solder layer lies in the range from substantially 5 µm to substantially 10 µm.

4. A method according to any of the preceding claims, wherein the depth of the depression (52) on the substrate (21) is between 5 and 10 µm.

5. A method according to any one of the preceding claims, wherein the solder layer is Sn, Au-Sn eutectic alloy, or Au-Si eutectic alloy.

6. A method according to any one of the preceding claims, wherein the solder layer is formed by plating or by evaporation.

7. A method according to any one of the preceding claims, wherein the electrode and the solder layer are both ring-shaped.

## Patentansprüche

1. Verfahren zur Herstellung einer optischen Anordnung mit Schritten, bei denen
ein Substrat (21, 41) vorgesehen wird, welches entweder durchsichtig oder mit einer Öffnung (24, 43) zum Hindurchlassen von Licht versehen ist,
auf dem Substrat (21, 41) eine Plättchenbondierunterlage (54, 42) gebildet wird und
auf die Plätchenbondierunterlage (54, 42) ein Chip (29, 37) mit einer optischen Anordnung bondiert wird, der an seiner bondierten Seite zum Einstrahlen oder Ausstrahlen von Licht angeordnet ist,
dadurch gekennzeichnet, daß der Chip (29, 37) mit der optischen Anordnung eine Elektrode (35) und eine Lotschicht (44) aufweist, die nacheinander auf seiner bondierten Seite ausgebildet worden sind, wobei die Lotschicht (44) eine vorbestimmte Dicke aufweist, die Lotschicht (44) und die Elektrode (35) eine Öffnung zum Hindurchlassen von Licht aufweisen, und der Chip mit der optischen Anordnung mittels der Lotschicht (44) mit der Plättchenbondierunterlage (54, 42) bondiert ist, daß der Schritt zum Vorsehen eines Substrats das Ausbilden einer Vertiefung (52) mit abgeschrägten Seiten (51) in der oberen Fläche des Substrats umfaßt, und
daß der Schritt zum Vorsehen einer Plättchenbondierunterlage (54) das Ausbilden der Unterlage (54) auf der oberen Fläche des Substrats (21) durch Aufdrucken und Einbrennen einer elektrisch leitenden Paste umfaßt, wobei die Kanten der elektrisch leitenden Paste (54) sich an den abgeschrägten Seiten (51) der Vertiefung (52) befinden, so daß nach dem Einbrennen die obere Kontaktfläche der Plättchenbondierunterlage (23) im wesentlichen flach ist.

2. Verfahren nach Anspruch 1, bei dem das Substrat (21) aus Saphir besteht.

3. Verfahren nach einem der vorstehenden Ansprüche, bei dem die vorbestimmte Dicke der Lotschicht im Bereich von im wesentlichen 5 µm bis im wesentlichen 10 µm liegt.

4. Verfahren nach einem der vorstehenden Ansprüche, bei dem die Tiefe der Vertiefung (52) auf dem Substrat (21) zwischen 5 und 10 µm beträgt.

5. Verfahren nach einem der vorstehenden Ansprüche, bei dem die Lotschicht aus Sn, eutektischer Au-Sn-Legierung oder eutektischer Au-Si-Legierung besteht.

6. Verfahren nach einem der vorstehenden Ansprüche, bei dem die Lotschicht durch Plattieren oder durch Aufdampfen gebildet wird.

7. Verfahren nach einem der vorstehenden Ansprüche, bei dem die Elektrode und die Lotschicht beide ringförmig sind.

## Revendications

1. Procédé pour la fabrication d'un dispositif optique, comprenant les étapes consistant à :
réaliser un substrat (21, 41), le substrat (21, 41) étant soit transparent ou présentant un trou (24, 43) pour laisser passer la lumière à travers celui-ci;
réaliser une plage de connexion par matriçage (54, 42) sur le substrat (21, 41); et
connecter par matriçage une pastille de dispositif optique (29, 37) disposée pour transmettre de la lumière dans ou hors de celle-ci depuis son côté connecté par matriçage (61) sur la plage de connexion par matriçage (54, 42);
caractérisé en ce que la pastille de dispositif optique (29, 37) présente une électrode (35) et une couche de soudure (44) séquentiellement formée sur son côté connecté par matriçage, la couche de soudure (66) possédant une épaisseur prédéterminée, la couche de soudure (44) et les électrodes (35) possédant un trou pour la transmission de la lumière, et en ce que la pastille de dispositif optique est connectée par matriçage à la plage de connexion par matriçage (54, 42) par la couche de soudure (44), et en ce que l'étape consistant à réaliser un substrat comprend :
la formation d'un creux (52) possédant des côtés inclinés (51) dans la surface supérieure du substrat (21);
et l'étape de la réalisation d'une plage de connexion par matriçage (54) comprend la réalisation de la plage (54) sur la surface supérieure du substrat (21) par impression et cuisson d'une pâte électroconductrice, les bords de la pâte électroconductrice (54) étant localisés sur les côtés inclinés (51) du creux (52) de façon qu'après la cuisson, la sur face de contact supérieure de la plage de connexion par matriçage (23) soit essentiellement plate.

2. Procédé selon la revendication 1, dans lequel le substrat (21) est un saphir.

3. Procédé selon l'une des revendications précédentes, dans lequel l'épaisseur prédéterminée de la couche de soudure se situe dans la plage comprise essentiellement entre 5 µm à essentiellement 10 µm.

4. Procédé selon l'une des revendications précédentes, dans lequel la profondeur du creux (52) sur le substrat (21) est comprise entre 5 et 10 µm.

5. Procédé selon l'une des revendications précédentes, dans lequel la couche de soudure est constituée par le Sn, l'alliage eutectique Au-Sn, ou l'alliage eutectique Au-Si.

6. Procédé selon l'une des revendications précédentes, dans lequel la couche de soudure est formée par placage ou par évaporation.

7. Procédé selon l'une des revendications précédentes, dans lequel l'électrode et la couche de soudure sont tous les deux de forme annulaire.
